# EUROPÄISCHE PATENTSCHRIFT

(11) **EP 3 084 832 B1**
(45) Veröffentlichungstag und Bekanntmachung des Hinweises auf die Patenterteilung: **08.04.2020**
(21) Anmeldenummer: 14828019.1
(22) Anmeldetag: 16.12.2014
(51) Int. Cl.: H01L 27/30

(54) **ORGANISCHES PHOTOVOLTAIKELEMENT, SOWIE VERFAHREN ZUR HERSTELLUNG EINES SOLCHEN**
ORGANIC PHOTOVOLTAIC ELEMENT AND METHOD FOR PRODUCING SAME
ÉLÉMENT PHOTOVOLTAÏQUE ORGANIQUE ET SON PROCÉDÉ DE FABRICATION

(30) Priorität: 17.12.2013 DE 102013226280
(43) Veröffentlichungstag der Anmeldung: 26.10.2016
(73) Patentinhaber: OPVIUS GmbH, 97318 Kitzingen (DE)
(72) Erfinder: ISSA, Hafis Hermann, 70186 Stuttgart (DE)
(74) Vertreter: FDST Patentanwälte
(86) Internationale Anmeldenummer: PCT/EP2014/078053
(87) Internationale Veröffentlichungsnummer: WO 2015/091543

(56) Entgegenhaltungen:
- EP-A2- 1 816 684
- DE-A1-102012 206 111
- JP-A- 2011 114 091
- US-A1- 2010 028 533

## Beschreibung

Die Erfindung betrifft ein organisches Photovoltaikelement, im Folgenden als OPV-Element bezeichnet, das sich in eine Längsrichtung erstreckt, mit einer Mehrzahl von Modulen, die jeweils eine Anzahl von in Serie verschalteten Zellen aufweisen. Die Erfindung betrifft weiterhin ein Verfahren zur Herstellung eines solchen OPV-Elementes.

Ein derartiges OPV-Element sowie Herstellungsverfahren ist beispielsweise der US 8,129,616 B2 zu entnehmen. Aus der US 2010/0028533 A1 ist ein Rollendruckverfahren zu entnehmen.

Aus der DE 10 2012 206 111 A1 ist ein organisches Photovoltaikelement mit unregelmäßig verlaufenden Leiterbahnen zu entnehmen. Das Photovoltaikelement setzt sich aus einer unregelmäßigen Abfolge von Einzelelementen zusammen, so dass das Einzelelement nur noch schwer zu erkennen ist.

Aus der JP 2011 114 091 A ist ein Photovoltaikelement zu entnehmen, welches dreieckförmige Elemente aufweist, welche zu einem Modul mit vier- oder mehreckiger Struktur zusammengesetzt sind.

Die EP 1 816 684 A2 beschreibt wiederum ein Photovoltaikelement mit einer Abfolge von hexagonalen Elementen.

Ein bevorzugtes Einsatzgebiet von OPV-Elementen ist die Erzeugung elektrischer Energie mittels Sonnenlicht. Dazu weisen OPV-Elemente eine Anzahl von aus einem organischen Halbleitermaterial hergestellten Zellen auf, in denen durch Absorption von Sonnenlicht freie Ladungsträger generiert werden. Das Halbleitermaterial ist typischerweise als dünner Film auf einer im Wesentlichen transparenten Trägerfolie aufgebracht. Die in den Zellen generierten Ladungsträger können über Kontakte abgegriffen und als Strom einem Verbraucher zugeführt werden. Die verfügbare Stromstärke und die von dem OPV-Element zur Verfügung gestellte Spannung sind unter Anderem von dem Aufbau des OPV-Elementes abhängig. Die von einer Zelle generierte Stromstärke ist hierbei im Wesentlichen durch die von dem Halbleitermaterial abgedeckte Fläche definiert; dagegen ist die Spannung im Wesentlichen durch die Bandlücke des Halbleitermaterials definiert und dementsprechend materialabhängig. Um eine bestimmte Spannung und eine bestimmte Stromstärke zu erzielen umfasst ein OPV-Element daher häufig mehrere Zellen, die entsprechend parallel und/oder seriell miteinander verschaltet sind. Entsprechend können auch mehrere OPV-Elemente zu einem OPV-Panel zusammengeschaltet werden.

Aus der US 8,129,616 B2 ist es bekannt, OPV-Elemente mit einer Rollendruckmaschine in einem Rollendruckverfahren derart herzustellen, dass die einzelnen Zellen streifenförmig ausgebildet und längs der Förderrichtung der zur Herstellung verwendeten Rollendruckmaschine ausgerichtet sind. Dabei wird auf einer insbesondere transparenten Trägerfolie, vorzugsweise einer Kunststofffolie, ein Halbleitermaterial als eine Anzahl von Endlosstreifen aufgebracht, die orthogonal zur Förderrichtung über zusätzlich aufgebrachte Elektroden in Serie verschaltet sind. In einem Bereich zwischen den Endlosstreifen sind die Elektroden jeweils benachbarter Zellen derart verbunden, dass eine Serienschaltung realisiert ist. Beispielsweise ist jeder Streifen 2 cm breit und der Abstand zwischen zwei benachbarten Streifen beträgt 2 mm. Zusätzlich sind im Randbereich des OPV-Elementes in Förderrichtung weitere Elektroden zum Anschluss eines Verbrauchers aufgebracht. Aufgrund der Endlosherstellung durch das Rollendruckverfahren kann ein OPV-Element als eine Bahn beliebiger Länge hergestellt werden. Die Breite der Bahn ist hierbei durch die Rollenbreite der Trägerfolie beschränkt.

Um eine sich in zwei Dimensionen beliebig erstreckende Fläche mit OPV-Elementen zu belegen, können mehrere OPV-Elemente, das heißt Bahnen, beispielsweise durch Überlappen von geeigneterweise im Randbereich der Bahnen aufgebrachten Kontakten zu einem Gesamtelement, nachfolgend auch als OPV-Panel bezeichnet, verschaltet werden. Da unterschiedlich lange Bahnen typischerweise unterschiedliche elektrische Eigenschaften aufweisen, ist deren Verschaltung in Hinblick auf die Effizienz des Gesamtelementes nachteilig. Geeigneterweise sind daher die Bahnen in Förderrichtung in etwa gleichgroße Module mit gleichen elektrischen Eigenschaften unterteilt, derart dass die die Zellen verbindenden Elektroden nicht endlos aufgebracht sind, sondern abschnittsweise. Hierdurch ergibt sich insbesondere ein nicht genutzter Abschnitt, im Folgenden auch als Totbereich bezeichnet, zwischen dem Ende einer ersten Elektrode und dem Beginn einer längs der Förderrichtung nachfolgenden Elektrode. Um Material einzusparen und das Verhältnis von ungenutzter zu genutzter Fläche zu reduzieren ist es vorteilhaft, den Totbereich durch geeignetes Ausformen und Anordnen sowie entsprechend angepasstes Verschalten der Zellen zu minimieren.

Desweiteren entsteht aufgrund eines durch die Endlosstreifen definierten Streifenmusters ein unerwünschter visueller Effekt, durch den insbesondere die Wahrnehmung der Form der belegten Fläche negativ beeinträchtigt wird.

Der Erfindung liegt die Aufgabe zugrunde, ein verbessertes und einfach herzustellendes OPV-Element anzugeben. Insbesondere soll die visuelle Wahrnehmung eines einzelnen OPV-Elementes, sowie mehrerer zu einem OPV-Panel angeordneter OPV-Elemente verbessert werden.

Diese Aufgabe wird erfindungsgemäß gelöst durch ein OPV-Element mit den Merkmalen des Anspruchs 1, sowie durch ein Verfahren gemäß dem Anspruch 14. Vorteilhafte Ausgestaltungen, Weiterbildungen und Varianten sind Gegenstand der Unteransprüche.

Hierzu ist vorgesehen, dass ein OPV-Element, das sich in eine Längsrichtung erstreckt, eine Mehrzahl von Modulen umfasst. Diese weisen jeweils eine Anzahl von in Serie verschalteten Zellen auf. Durch eine periodische Abfolge einer Anzahl von Modulen ist ein Muster mit wenigstens dreizähliger Rotationssymmetrie definiert. Eine Zelle ist hierbei eine kleinste, elektrische Einheit. Mehrere Zellen können in Serie und/oder parallel miteinander verschaltet werden, wodurch die von dem OPV-Element erzeugte Spannung und Stromstärke definiert sind. Hierzu ist insbesondere eine Anzahl von Zellen jeweils zu einem Modul zusammengefasst. Alle Module eines OPV-Elementes weisen bevorzugt gleiche elektrische Eigenschaften auf.

Jedes der Module umfasst eine Anzahl von Untermodulen, die über eine Anzahl von Verbindungselektroden verschaltet sind. Jedes der Untermodule umfasst eine Anzahl von Zellen. Üblicherweise sind zur Kontaktierung der Zellen miteinander für jede Zelle zwei Pole vorgesehen. Während eine Anzahl von Zellen durch direkte Kontaktierung der entsprechenden Pole miteinander zu Untermodulen verschaltet werden können, kann es aufgrund der gewählten Anordnung der Zellen jedoch notwendig sein, zusätzliche Verbindungselektroden vorzusehen, um mehrere Untermodule, deren zu kontaktierende Pole nicht direkt verbunden sind, elektrisch zu verbinden.

Weiterhin ist jedes der Untermodule trapezförmig und umfasst jeweils zwei erste Grundseiten. Durch eine Trapezform lässt sich die visuelle Struktur eines insbesondere dreieckigen Moduls derart gestalten, dass dieses eine dreizählige Rotationssymmetrie aufweist. Insbesondere weist jedes Modul genau drei trapezförmige Untermodule auf.

Insbesondere umfasst das OPV-Element zur Generierung von Ladungsträgern ein organisches Halbleitermaterial, das als dünner Film auf einer insbesondere im Wesentlichen transparenten Trägerfolie aufgebracht ist. Diese bildet dann mit dem Halbleitermaterial und möglichen weiteren funktionalen Schichten eine folienartige Schichtstruktur. Das gesamte OPV-Element ist daher nach Art einer Folie ausgebildet. Die einzelnen Module sind innerhalb der Schichtstruktur ausgebildet durch eine geeignete Strukturierung und elektrischen Verschaltung der Schichten. Alle Module des OPV-Elementes sind gemeinsam auf der einzelnen Trägerfolie aufgebracht. Die Module bilden daher auf der gemeinsamen Trägerfolie eine insbesondere periodisch vielfach wiederkehrende Struktur aus. Die Trägerfolie und somit auch das OPV-Element sind dann vorteilhaft konfektionierbar, sodass die Form des OPV-Elementes nachträglich anpassbar ist.

Die Zellen und die diese umfassenden Modulen bilden aufgrund der absorbierenden Halbleiterschicht auch visuelle Einheiten. Um einen ansprechenden visuellen Eindruck zu erzielen, sind die Module und die jeweils von diesen umfassten Zellen derart angeordnet, dass der Eindruck eines periodischen Musters entsteht. Unter periodischer Abfolge wird hierbei verstanden, dass eine Anzahl von Modulen insbesondere unter Berücksichtigung der Anordnung der darin enthaltenen Zellen durch Aneinanderreihen eine zweidimensionale Fläche derart ausfüllt, dass sich ein hochsymmetrisches, hier wenigstens dreizählig rotationssymmetrisches Muster ergibt. Unter dreizähliger Rotationssymmetrie wird hierbei verstanden, dass das Muster und vorteilhafterweise auch ein einzelnes Modul durch dreifache Drehung um einen jeweils geeigneten Drehpunkt auf sich selbst abgebildet wird. Hierdurch ist die ursprüngliche Förderrichtung der Rollendruckmaschine weniger deutlich zu erkennen, wodurch ein homogener, visueller Eindruck entsteht. Durch die dreizählige Rotationssymmetrie werden größere Designfreiheiten bei dem Verknüpfen einzelner OPV-Elemente zu übergeordneten OPV-Paneelen geschaffen. Durch die dreizählige Symmetrie wird daher die streifenförmige Optik bisheriger OPV-Elemente vermieden und es lassen sich große, variabel zu konfigurierende Flächenbereiche erzeugen.

Das OPV-Element ist vorteilhafterweise in einem Rollendruckverfahren herstellbar, insbesondere aufgrund der Periodizität des Musters. Hierdurch können beliebig lange OPV-Elemente gefertigt werden. Zur Gestaltung auch beliebig breiter Flächen können mehrere OPV-Elemente nebeneinander verwendet werden. Unerwünschte visuelle Effekte werden dabei durch die hohe Symmetrie des Musters vermieden. Grundsätzlich ist durch die Verwendung insbesondere von zumindest dreizähligen Modulen es ermöglicht, eine variable, großflächige OPV-Paneele zusammen zu stellen mit im Vergleich zu Streifenmustern verbessertem ästhetischen Erscheinungsbild, gleichzeitig ist dies mit der Möglichkeit einer kostengünstigen Endlosherstellung insbesondere durch ein Rollendruckverfahren kombiniert. Von besonderer Bedeutung ist hierbei auch, dass durch die Aneinanderreihung der Module ein periodisches Endlos-Muster bereitgestellt ist, welches sich nahezu zu beliebigen Flächen ausbilden lässt.

In einer vorteilhaften Ausgestaltung ist jedes der Module polygonförmig. Hierdurch lässt sich insbesondere eine gute Flächenausnutzung erzielen. Geeigneterweise ist jedes der Module dreieckförmig. Dadurch lässt sich ein hochsymmetrisches Muster mit besonders guter Flächenausnutzung erzeugen. Dabei ist die Periodizität des Musters vorteilhafterweise durch eine durch zwei Module mit einer gemeinsamen Dreiecksseite gebildete Raute definiert und die Raute ist bezüglich der Anordnung der von dieser umfassten Zellen spiegelsymmetrisch entlang der Dreiecksseite. Beispielsweise weist jedes Modul die Form eines gleichseitigen Dreiecks auf. Durch Spiegelung des Dreiecks an einer seiner Grundseiten ergibt sich eine Raute, mit der eine zweidimensionale Fläche durch Aneinanderreihung mehrerer Rauten lückenlos gefüllt werden kann. Ein aus drei Rauten gebildetes Sechseck (auch Hexagon) kann ebenfalls hierzu verwendet werden. Durch diese Wahl ergibt sich ein hoher geometrischer Füllfaktor, das heißt ein großes Verhältnis von durch Zellen belegte Fläche zur Gesamtfläche.

Weiterhin bevorzugt ist jede Zelle trapezförmig und weist zwei zweite Grundseiten auf, die jeweils parallel zu den ersten Grundseiten des die jeweilige Zelle umfassenden Untermoduls sind. In dieser Ausführung sind mehrere Zellen trapezförmig, das heißt als Streifen mit abgeschrägten Enden ausgebildet. Mehrere solcher Streifen sind derart nebeneinander zu einem Untermodul angeordnet, dass dieses ebenfalls trapezförmig ist. Im Falle eines gleichseitig dreieckigen Moduls können drei gleichartige, trapezförmige Untermodule derart angeordnet sein, dass die Untermodule das Dreieck nachbilden. Das Dreieck weist dann eine dreizählige Rotationssymmetrie auf, wobei der Mittelpunkt des Dreiecks ein entsprechender Symmetriepunkt ist.

Vorteilhafterweise definiert jede der Zellen jeweils eine Fläche und die Flächen unterscheiden sich um weniger als 10%. Hierdurch sind insbesondere die elektrischen Eigenschaften aller Zellen ähnlich, wodurch ein Leistungsabfall durch Verschalten der Zellen miteinander vermieden werden kann.

In einer bevorzugten Ausgestaltung weist jede Zelle eine Zellenhöhe auf und die Zellenhöhen unterscheiden sich um weniger als 100%, vorzugsweise weniger als 30%. Im Falle trapezförmiger Zellen eines trapezförmigen Untermoduls wird der visuelle Eindruck durch Zellen mit ähnlicher Zellenhöhe, das heißt ähnlichem Abstand der beiden Grundseiten des Trapezes, verbessert. Da die Zellen hierbei jedoch nicht gleich breit sind und vorteilhafterweise eine möglichst gleiche Fläche aufweisen, ist ein maximaler Unterschied von 100% vorgesehen, das heißt, die größte Zellenhöhe ist höchstens doppelt so groß wie die kleinste Zellenhöhe. Bevorzugterweise beträgt der Unterschied jedoch höchstens 30%.

In einer vorteilhaften Weiterbildung ist das OPV-Element als eine sich in die Längsrichtung erstreckende Endlosbahn (Endlosfolie) mit einer Anzahl von sich in die Längsrichtung erstreckenden Kontaktschienen ausgebildet. Unter Endlosbahn wird hierbei verstanden, dass die maximale Länge in der Längsrichtung nicht durch die Anordnung der Zellen und der Module definiert ist, sondern beispielsweise durch die maximal verfügbare Länge des Trägermaterials. Die Kontakschienen verlaufen in Längsrichtung und sind typischerweise parallel zueinander.

In einer bevorzugten Weiterbildung weist jedes Modul einen Minuspol und einen Pluspol auf und die Kontaktschienen verbinden jeweils entweder eine Anzahl von Minuspolen oder eine Anzahl von Pluspolen. Beispielsweise sind die Kontaktschienen aus einem elektrisch leitenden Material gefertigt und verbinden eine Mehrzahl von Modulen, derart dass die durch das OPV-Element erzeugten Ladungsträger über die Kontaktschienen gesammelt und abgegriffen werden können. Jede Kontaktschiene verbindet dabei entweder ausschließlich Pluspole oder ausschließlich Minuspole, wodurch Kontaktschienen beider Polaritäten vorhanden sind. Mehrere Kontaktschienen gleicher Polarität können weiterhin miteinander verbunden werden, derart dass die gesamte elektrische Leistung des OPV-Elementes über ein einziges Polpaar zugänglich ist. Insbesondere kann dadurch ein Verbraucher über das Polpaar mit dem OPV-Element elektrisch verbunden werden.

Bei einem Rollendruckverfahren wird während des Herstellungsprozesses die Endlosbahn, auf der die unterschiedlichen Schichten zur Ausbildung des OPV-Elements aufgebracht werden, mehrfach umgelenkt. Problematisch hierbei ist, dass die aufgebrachten Beschichtungen, insbesondere das aufgebrachte Halbleiter-Material, mechanisch nicht belastet werden dürfen. In zweckdienlicher Ausgestaltung ist nunmehr vorgesehen, dass die Kontaktschienen zusätzlich als mechanisch belastbare Ansatzpunkte für Umlenkrollen einer Rollendruckmaschine im Rahmen des Rollendruckverfahrens ausgebildet sind.

Hierdurch ist eine Beschädigung beispielsweise der Halbleiterschichten vermieden. Zweckdienlicherweise sind die Kontaktschienen aus einem mechanisch belastbaren Material gefertigt, beispielsweise als Metallstreifen oder auch als Litzenleiter ausgebildet, und als vorgefertigte Leiterstreifen aufgebracht. Beispielsweise sind die Kontaktschienen aufgeklebt.

In einer bevorzugten Ausgestaltung sind alle Module parallel verschaltet. Die durch ein Modul erzeugte Spannung gibt daher auch die Spannung des gesamten OPV-Elementes vor. Durch die Parallelschaltung wird die Stromstärke maximiert. In einer vorteilhaften Weiterbildung sind alle Zellen eines Moduls in Serie verschaltet. Durch die Auswahl einer geeigneten Anzahl von in Serie verschalteten Zellen kann somit insbesondere die Spannung des Moduls und in Verbindung mit ausschließlich parallel verschalteten Modulen die Spannung des gesamten OPV-Elementes definiert werden. Geeigneterweise ist es dadurch auch möglich, das OPV-Element entlang von durch die Module definierten Kanten beliebig abzulängen. Durch die gewählte Verschaltung stellen unterschiedlich lange OPV-Elemente die gleiche Spannung bereit. Durch die Wahl einer geeigneten Modulform, beispielsweise einer Dreiecks- oder Sechseckform, können hierdurch beliebig geformte Flächen mit einem oder mehreren OPV-Elementen im Wesentlichen vollständig belegt werden.

Das OPV-Element weist insbesondere eine Schichtstruktur auf und eine Trägerfolie, wobei die Schichtstruktur mittels eines Rollendruckverfahrens ausgebildet ist. Die Trägerfolie ist insbesondere einstückig ausgeführt und die zur Ausbildung des OPV-Elementes nötigen funktionalen Schichten sind entsprechend darauf aufgebracht und die dadurch ausgebildeten Zellen und Module sind geeignet miteinander verschaltet. Dies ist in einem Rollendruckverfahren besonders kosteneffizient und mit hoher Fertigungsgeschwindigkeit durchführbar. Die einzelnen Zellen sind bezüglich der durch die Trägerfolie definierten Fläche in zwei Dimensionen insbesondere nebeneinander angeordnet und durch entsprechende Kontaktierungen elektrisch miteinander verschaltet. In einer geeigneten Variante sind auf einer entsprechend dimensionierten Trägerfolie auch mehrerer OPV-Elemente gemeinsam aufgebracht und dabei aber insbesondere nicht notwendigerweise elektrisch miteinander verschaltet.

Zur Ausbildung eines OPV-Panels sind vorzugsweise mehrere OPV-Elemente nebeneinander angeordnet. Die OPV-Elemente sind also bezüglich ihrer jeweiligen Längsrichtung parallel zueinander ausgerichtet sind. Insbesondere im Fall von in Längsrichtung verlaufenden Kontaktschienen ist hierdurch das Belegen beliebiger Flächen durch eine Anzahl von OPV-Elementen und das gesammelte Abgreifen der erzeugten Ladungsträger ermöglicht.

Die mit der Erfindung erzielten Vorteile bestehen insbesondere darin, dass das OPV-Element in einem Rollendruck- oder Rollenauftragungsverfahren als Bahn hergestellt werden kann. Hierbei wird eine Trägerfolie über eine Anzahl von Umlenkrollen durch eine Rollendruckmaschine geführt oder gefördert und in einer Anzahl von Verfahrensschritten bearbeitet. Insbesondere werden dabei mindestens eine Funktionsschicht, beispielsweise eine Halbleiterschicht sowie Elektroden aufgetragen oder aufgedruckt. Desweiteren werden die verschiedenen Schichten in einem oder mehreren zusätzlichen Verfahrensschritten strukturiert. Hierdurch werden funktionelle Bereiche, beispielsweise Elektroden oder die Zellen des OPV-Elementes wunschgemäß ausgestaltet. Bevorzugt wird zur Strukturierung ein Laser verwendet, der eine hohe Präzision bei der Strukturierung und somit einen hohen Füllfaktor ermöglicht. Vorzugsweise wird ein Freiformlaser verwendet, der insbesondere unabhängig von der Förderbewegung der Rollendruckmaschine angesteuert und verfahren werden kann. Insbesondere ist der Freiformlaser quer zur Förderrichtung und damit quer zur Längsrichtung verfahrbar. Auf diese Weise wird eine hohe Flexibilität bei der Gestaltung des Musters sowie bei der Ausbildung der Elektroden und somit der Verschaltung der Zellen und Module erreicht.

Die Breite eines in einem Rollendruck- oder Rollenauftragungsverfahren hergestellten OPV-Elementes, das heißt einer Bahn, ist durch die Rollenbreite der Trägerfolie gegeben, die Länge durch die verfügbare Abrolllänge. Vorteilhafterweise erstrecken sich die Kontaktschienen in der Förderrichtung der Rollendruckmaschine und können hierdurch gleichzeitig als Angriffspunkte für Umlenkrollen derselben dienen.

Ein weiterer Vorteil ist, dass das durch die Anordnung der Module erzeugte Muster hochsymmetrisch ist, wodurch eine Anzahl von OPV-Elementen, das heißt eine Anzahl von Bahnen, derart nebeneinander angebracht werden können, dass die Längsrichtung der Bahn im Wesentlichen nicht erkennbar ist. Ein hochsymmetrisches Muster ist beispielsweise durch gleichseitig dreieckige Module definiert, die jeweils drei trapezförmige Untermodule umfassen, wobei die Untermodule jeweils eine Anzahl von nebeneinander angeordneten Zellen umfassen. Durch Spiegelung eines Moduls an einer der Dreiecksseiten wird insbesondere auch eines der trapezförmigen Untermodule an seiner längeren Grundseite gespiegelt, derart dass dieses Untermodul und sein Spiegelbild ein Sechseck (Hexagon) bilden. Insbesondere sind alle Grundseiten der von diesem Hexagon umfassten, trapezförmigen Zellen zueinander parallel.

Ein weiterer Vorteil besteht darin, dass durch das gewählte Muster ein hoher geometrischer Füllfaktor erzielt und der Totbereich gering ist. Dadurch ist insbesondere die pro Fläche erzeugte Leistung des OPV-Elementes verbessert.

Nachfolgend werden Ausführungsbeispiele der Erfindung anhand einer Zeichnung näher erläutert. Darin zeigen:
- Fig. 1: eine schematische Darstellung eines Moduls eines OPV-Elementes,
- Fig. 2: eine schematische Darstellung eines Ausschnittes eines OPV-Elementes mit Modulen gemäß Fig. 1,
- Fig.3: eine schematische Darstellung eines Ausschnittes eines weiteren OPV-Elementes mit Modulen gemäß Fig. 1,
- Fig. 4: eine schematische Darstellung der Zellenanordnung eines OPV-Panels aus mehreren OPV-Elementen gemäß Fig. 3, und
- Fig. 5: eine schematische Darstellung eines Rollendruckverfahrens.

Einander entsprechende Teile sind in allen Figuren mit den gleichen Bezugszeichen versehen.

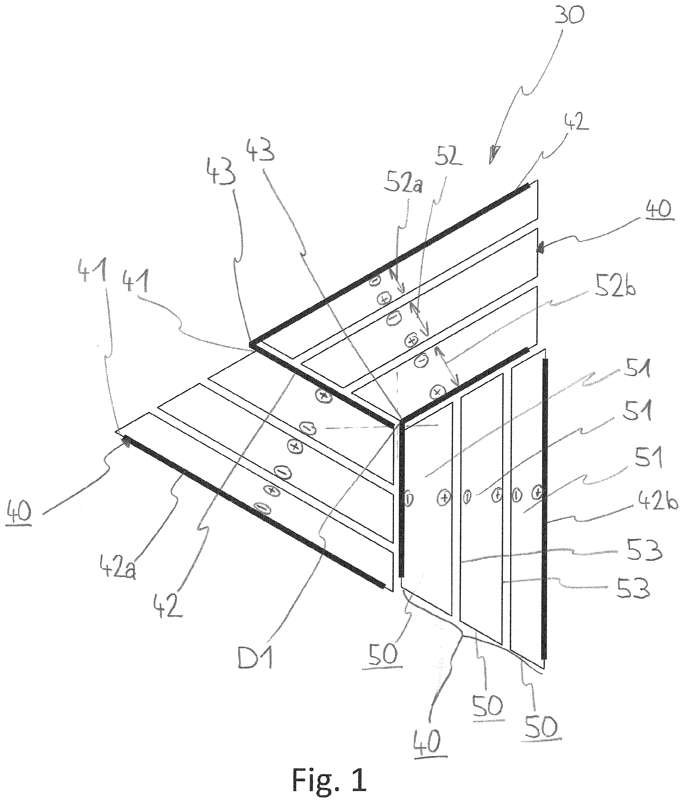

Fig. 1 zeigt eine schematische Darstellung eines dreieckig ausgebildeten Moduls 30, das drei Untermodule 40 mit jeweils drei Zellen 50 umfasst. Die Zellen 50 eines Untermoduls 40 sind trapezförmig und in Serie verschaltet und jeweils parallel zueinander orientiert. Die Polung der einzelnen Zellen 50 ist jeweils in der Figur 1 angegeben. Hieraus ist zu erkennen, dass die einzelnen Zellen 50 eines jeweiligen Untermoduls 40 zueinander in Serie verschaltet sind und darüber hinaus auch zu den weiteren Zellen 50 der weiteren Untermodule 40 in Serie verschaltet sind. Die einzelnen Untermodule 40 des Moduls 30 sind zueinander verdreht, und zwar jeweils um 120°.

Die Zellen 50 weisen dabei jeweils photoaktive Flächen 51 auf. Die Flächen 51 sind dabei definiert durch diejenigen Bereiche, die unterbrechungsfrei das photoaktive organische Halbleitermaterial aufweisen, welches eine charakteristische Färbung hat. In den Zwischenbereichen zwischen den einzelnen Zellen 50 liegt dieses Halbleitermaterial nicht vor. Die Flächen 51 werden durch eine Strukturierung beim Herstellverfahren definiert. Über die Zwischenbereiche zwischen den einzelnen Zellen 50 erfolgt die wechselseitige elektrische Verschaltung der einzelnen Zellen 50 miteinander. Die Flächen 51 der Zellen 50 sind etwa gleich groß, unterscheiden sich vorzugsweise um weniger als 10% voneinander. Um dies zu erreichen nimmt die Zellenhöhe 52 der Zellen 40 des Untermoduls zu. Bevorzugt jedoch nur derart, dass benachbarte Zelle 50 sich in ihrer Zellenhöhe 52 um weniger als 30% unterscheiden, die kleinste und die größte Zellenhöhe 52a, 52b unterscheiden sich insbesondere maximal um etwa 50%. Jedes Untermodul 40 ist trapezförmig und weist erste Grundseiten 41 auf, die parallel zu zweiten Grundseiten 53 der von diesen umfassten Zellen 50 orientiert sind. Das Modul 30 ist unter Berücksichtigung der Anordnung der Zellen 40 dreizählig rotationssymmetrisch bezüglich eines Drehpunktes D1.

Jedes Untermodul 40 weist an beiden Grundseiten 41 jeweils einen Pol 42 zur Verschaltung auf. Insgesamt weist das Modul 30 sechs Pole 42 auf. Die drei Untermodule 40 sind in Serie miteinander verschaltet. Um die Pole 42 der drei Untermodule 40 miteinander zu verschalten, sind zusätzliche Verbindungselektroden 43 vorgesehen. Diese verbinden jeweils zwei benachbarte, über Eck liegende Trapezseiten miteinander. Das Modul 30 ist somit eine Reihenschaltung von neun Zellen 50, wobei einer der Pole 42 ein Minuspol 42a und ein weiterer der Pole 42 ein Pluspol 42b ist, über die das Modul 30 mit weiteren Modulen verschaltet werden kann.

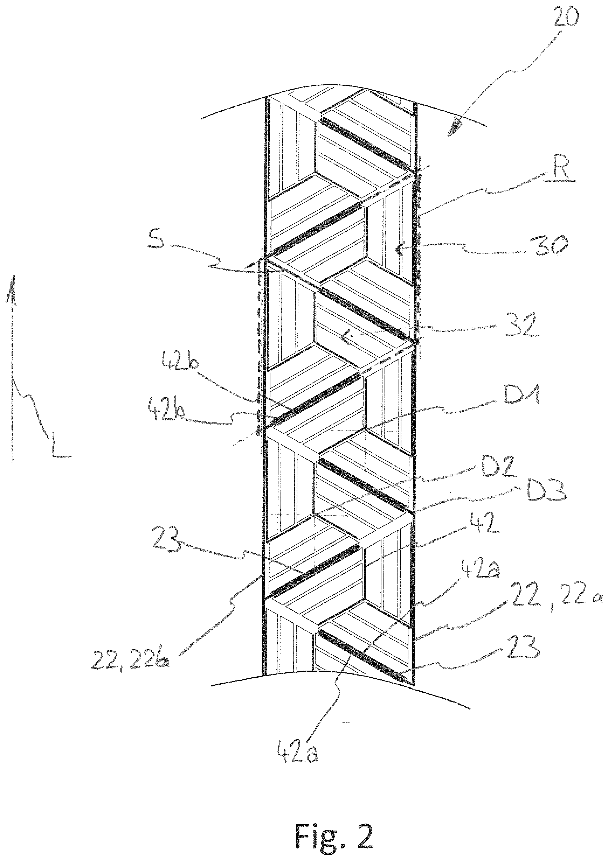

Fig.2 zeigt in schematischer Darstellung eine Aneinanderreihung von ersten und zweiten Modulen 30, 32 zu einem sich in eine Längsrichtung L endlos erstreckenden OPV-Element 20. Das durch die Zellen 50 gebildete Muster ist periodisch. Die Periodizität ist durch eine Raute R definiert, die aus einem ersten Modul 30 gemäß Fig. 1 und einem zweiten Modul 32 besteht, wobei das zweite Modul 32 ein Spiegelbild des ersten Moduls 30 entlang einer der Dreiecksseiten S des ersten Moduls 30 ist. Eine der Rauten R ist beispielhaft durch eine gestrichelte Linie zur besseren Veranschauung hervorgehoben. Durch Aneinanderreihen der zwei Module 30,32 wird insbesondere ein dreizählig rotationssymmetrisches Muster mit Drehpunkten D1, D2, D3 gebildet. Durch die Aneinanderreihung der Rauten R in Längsrichtung L ist eine Grundbahn des OPV-Elements 20 geschaffen, die in einfacher Weise durch ein Rollendruckverfahren herstellbar ist. Je nach Breite der Rollendruckvorrichtung können mehrere derartiger Grundbahnen seitlich nebeneinander aneinandergereiht werden.

Die Grundbahn weist typischerweise eine Breite im Bereich von einigen Zentimetern, beispielsweise im Bereich von 5 bis 15 cm auf. Sie entspricht somit im Ausführungsbeispiel der (Dreiecks-) Höhe eines jeweiligen Moduls 30,32. Die einzelnen Zellen 50 wiederum weisen eine Höhe auf, also einen Abstand zwischen den beiden zweiten Grundseiten 53, die etwa im Bereich von typischerweise 0,5cm bis 2cm liegt.

Entlang der Längsrichtung L erstrecken sich an den Rändern 21 des OPV-Elementes 20 zwei Kontaktschienen 22, die über Kontaktarme 23 mit den Polen 42 verbunden sind. Die Kontaktschienen 22 sind als Minuskontrollschiene 22a und als Pluskontaktschiene 22b ausgebildet, die mit den Minuspolen 42a beziehungsweise den Pluspolen 42b der jeweiligen Module 30, 32 über die Kontaktarme 23 verbunden sind. In dem hier gezeigten Ausführungsbeispiel sind alle Zellen 50 eines jeden Moduls 30, 32 in Serie verschaltet und die Module 30 sind parallel zu den Modulen 32 verschaltet.

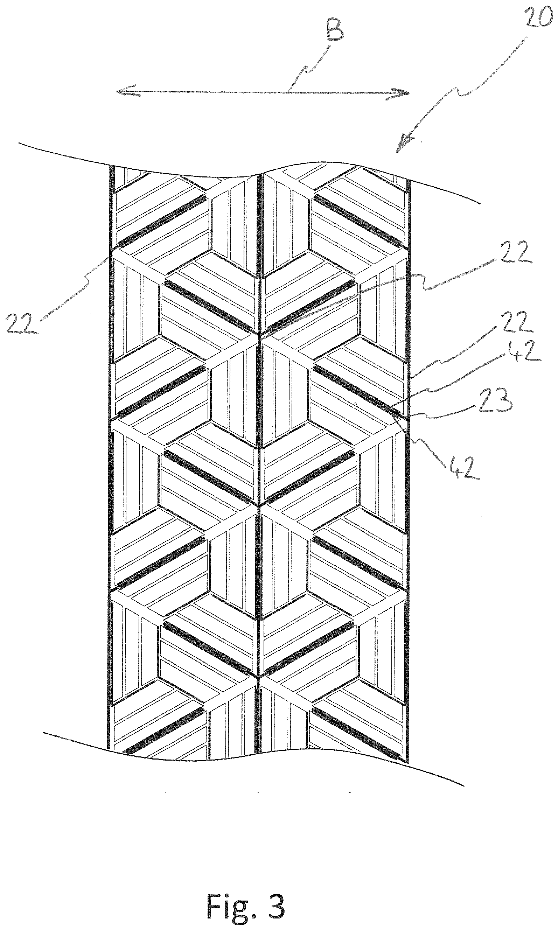

Fig. 3 zeigt in schematischer Darstellung einen Ausschnitt eines OPV-Elementes 20 ähnlich dem in Fig. 2 gezeigten, wobei nunmehr zwei Grundbahnen nebeneinander angeordnet sind. Dadurch weist das OPV-Modul eine etwa doppelte Breite B sowie bevorzugt drei Kontaktschienen 22 auf. Insbesondere weisen aufeinanderfolgende Kontaktschienen 22 unterschiedliche Polaritäten auf, das heißt, die beiden äußeren Kontaktschienen 22 weisen die gleiche Polarität auf. Dies vereinfacht insbesondere das parallele Verschalten mehrere solcher OPV-Elemente 20 zu einem OPV-Panel 10.

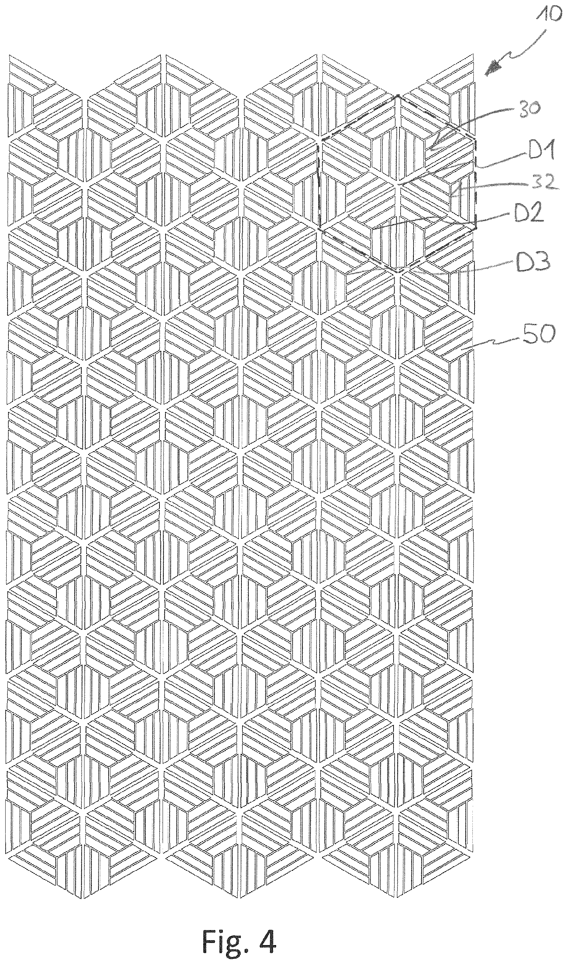

Fig. 4 zeigt in schematischer Darstellung die Anordnung der Zellen 50 eines aus mehreren OPV-Elementen 20 gemäß Fig. 4 gebildeten OPV-Panels 10. Das durch die Zellen 50 gebildete Muster ist dreizählig rotationssymmetrisch, beispielsweise bezüglich der Drehpunkte D1, D2, D3. Aufgrund der speziellen Ausgestaltung der Module als gleichseitige Dreiecke mit den insgesamt drei identischen trapezförmigen Untermodulen 40 mit den einzelnen Zellen 50 weist das dadurch gebildete Muster insgesamt eine hexagonale Überstruktur auf. Diese erzeugt insgesamt zum einen ein sehr ansprechendes Design und erlaubt zum anderen auch, Panele 10 mit unterschiedlichsten Flächengestaltungen ohne Vorzugsrichtung zusammenzustellen. Die hexagonale Überstruktur spiegelt sich zum einen in kleinen Hexagonen wieder, die durch zwei mit ihren ersten Grundseiten 41 aneinander angrenzende trapezförmige Untermodule 40 gebildet sind. Zum anderen spiegelt sich die hexagonale Überstruktur in großen Hexagonen wieder, die durch sechs der Module 30,32 gebildet sind, welche beispielsweise um den Drehpunkt D1 herum angeordnet sind. Zur Verdeutlichung ist diese hexagonale Anordnung der Module 30, 32 in der Figur 4 durch eine gestrichelte Linie hervorgehoben.

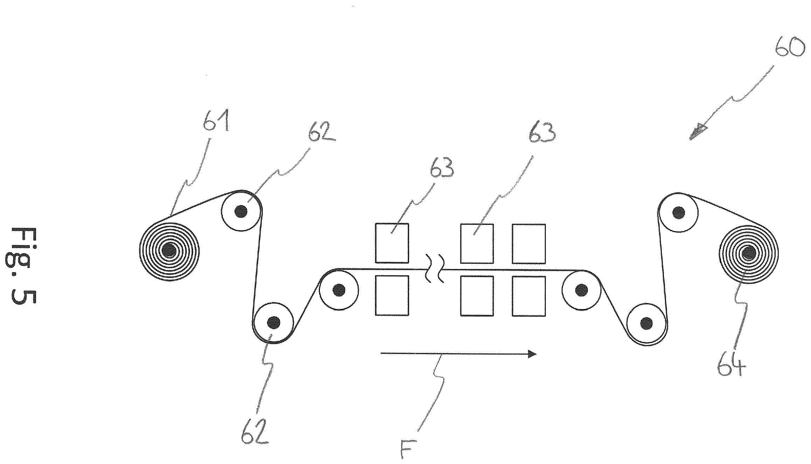

Insgesamt ist das in Figur 4 dargestellte dreizählige Flächenmuster aufgebaut aus der Zusammensetzung einer Vielzahl von in Figur 2 dargestellten Endlos-Grundbahnen, die sich jeweils durch eine periodische Abfolge der Rauten R ergeben, wobei jede Raute R wiederum aus den beiden Modulen 30, 32 gebildet Fig. 5 zeigt in schematischer Darstellung eine Rollendruckmaschine 60 zur Herstelllung eines OPV-Elementes 20 gemäß einer der Fig. 2 oder 3 durch ein Rollendruckverfahren. Die Trägerfolie 61 liegt in Rollenform vor und wird in Förderrichtung F über eine Anzahl von Umlenkrollen 62 geführt. Die Trägerfolie 61 stützt sich im Umlenkbereich mit der einen Seite an den Kontaktschienen 22 an den Umlenkrollen 62 ab. Die Förderrichtung F ist daher gleich der Längsrichtung L. Die Umlenkrollen 62 sind hierzu mit umlaufenden Kontaktringen beispielsweise Gummiringe versehen, an denen sich die Kontaktschienen 22 abstützen. Zusätzlich wird die Trägerfolie 61 in einer Anzahl von Verfahrensschritten in bekannter Weise bearbeitet. Die Verfahrensschritte sind hier schematisch durch in Förderrichtung F aufeinanderfolgende Stationen 63 dargestellt. Verfahrensschritte sind unter anderem das Aufbringen mindestens einer funktionellen Schicht, beispielsweise der Halbleiterschicht und mindestens eines Elektrodenmaterials. Nach der Bearbeitung wird die bearbeitete Trägerfolie 61, also das zunächst als Endlos-Bahn hergestellte OPV-Element 20, zu einer Rolle 64 aufgerollt.

Aus diesem lassen sich dann nahezu beliebige Panel-Flächen durch geeignete Aneinanderreihung und Zuschneiden der OPV-Elemente 20 zusammenstellen. Es besteht daher ausgehend von den Grundbahnen eine hohe Designfreiheit. Durch das spezielle zumindest dreizählige Muster, insbesondere mit der hexagonalen Überstruktur, ist insgesamt ein ansprechendes Design bei großer Designfreiheit der Fläche erzielt. Aufgrund der parallelen Verschaltung der Module 30,32 ist ein beliebiges Ablängen der OPV-Elemente 20 ermöglicht und es können auch Elemente 20 unterschiedlicher Längen problemlos miteinander verschaltet werden. Durch die spezielle Strukturierung in Untermodule 40 und Zellen 50, die jeweils zumindest weitgehend gleiche Flächen 51 sowie angepasste Zellenhöhen 52 aufweisen, ist zudem auch eine hohe elektrische Photoausbeute sichergestellt. Durch die Form der Module 30, 32 ist zudem ein hoher geometrischer Füllfaktor und damit eine hohe Lichtausbeute erreicht.

**Bezugszeichenliste**

| | | | |
|---|---|---|---|
| 10 | OPV-Panel | L | Längsrichtung |
| 20 | OPV-Element | R | Raute |
| 22 | Kontaktschiene | S | Dreiecksseite |
| 22a | Minus Kontaktschiene | | |
| 22b | Plus Kontaktschiene | | |
| 23 | Kontaktarm | | |
| 30 | Modul | | |
| 32 | Modul | | |
| 40 | Untermodul | | |
| 41 | erste Grundseite | | |
| 42 | Pol | | |
| 42a | Minuspol | | |
| 42b | Pluspol | | |
| 43 | Verbindungselektrode | | |
| 50 | Zelle | | |
| 51 | Fläche | | |
| 52 | Zellenhöhe | | |
| 52a | Zellenhöhe | | |
| 52b | Zellenhöhe | | |
| 53 | zweite Grundseite | | |
| 60 | Rollendruckmaschine | | |
| 61 | Trägerfolie | | |
| 62 | Umlenkrolle | | |
| 63 | Station | | |
| 64 | Rolle | | |
| | | | |
| B | Breite | | |
| D1 | Drehpunkt | | |
| D2 | Drehpunkt | | |
| D3 | Drehpunkt | | |
| F | Förderrichtung | | |

## Patentansprüche

1. Organisches Photovoltaik(OPV)-Element (20), das sich in eine Längsrichtung (L) erstreckt, mit einer Mehrzahl von Modulen (30, 32), wobei eine periodische Abfolge einer Anzahl der Module (30, 32) ein Muster mit wenigstens dreizähliger Rotationssymmetrie definiert, und jedes der Module (30, 32) eine Anzahl von Untermodulen (40) umfasst, die über eine Anzahl von Verbindungselektroden (43) verschaltet sind, dadurch charakterisiert, dass die Mehrzahl von Modulen (30, 32) jeweils eine Anzahl von in Serie verschalteten Zellen (50) aufweist, und dass
jedes der Untermodule (40) trapezförmig mit jeweils zwei ersten Grundseiten (41) ausgebildet ist und eine Anzahl von Zellen (50) umfasst.

2. OPV-Element (20) nach Anspruch 1,
**dadurch gekennzeichnet,**
**dass** jedes der Module (30, 32) polygonförmig ist.

3. OPV-Element (20) nach einem der vorhergehenden Ansprüche,
**dadurch gekennzeichnet,**
**dass** jedes der Module (30, 32) dreieckförmig ist.

4. OPV-Element (20) nach Anspruch 3,
**dadurch gekennzeichnet,**
**dass** die Periodizität des Musters durch eine durch zwei Module (30, 32) mit einer gemeinsamen Dreiecksseite (S) definierten Raute (R) definiert ist und die Raute (R) bezüglich der Zellen (50) spiegelsymmetrisch entlang der Dreiecksseite (S) ist.

5. OPV-Element (20) nach einem der vorhergehenden Ansprüche ,
**dadurch gekennzeichnet,**
**dass** jede Zelle (50) trapezförmig ist und zwei zweite Grundseiten (53) aufweist, die jeweils parallel zu den ersten Grundseiten (41) des die jeweilige Zelle (50) umfassenden Untermoduls (40) sind.

6. OPV-Element (20) nach einem der vorhergehenden Ansprüche,
**dadurch gekennzeichnet,**
**dass** jede der Zellen (50) jeweils eine Fläche (51) definiert und die Flächen (51) unterschiedlicher Zellen (50) sich um weniger als 10% unterscheiden.

7. OPV-Element (20) nach einem der vorhergehenden Ansprüche,
**dadurch gekennzeichnet,**
**dass** jede Zelle (50) eine Zellenhöhe (52) aufweist und die Zellenhöhen (52) sich um weniger als 100%, vorzugsweise um weniger als 30%, unterscheiden.

8. OPV-Element (20) nach einem der vorhergehenden Ansprüche,
**dadurch gekennzeichnet,**
**dass** es als eine sich in die Längsrichtung (L) erstreckende Endlosbahn mit einer Anzahl von sich in die Längsrichtung (L) erstreckenden Kontaktschienen (22) ausgebildet ist.

9. OPV-Element (20) nach Anspruch 8,
**dadurch gekennzeichnet,**
**dass** jedes Modul (30) einen Minuspol (42a) und einen Pluspol (42b) aufweist und die Kontaktschienen (22) jeweils entweder eine Anzahl von Minuspolen (42a) oder eine Anzahl von Pluspolen (42b) elektrisch verbinden.

10. OPV-Element (20) nach einem der vorhergehenden Ansprüche,
**dadurch gekennzeichnet,**
**dass** alle Module (30, 32) parallel verschaltet sind.

11. OPV-Element (20) nach einem der vorhergehenden Ansprüche,
**dadurch gekennzeichnet,**
**dass** alle Zellen (50) eines Moduls (30, 32) in Serie verschaltet sind.

12. OPV-Element (20) nach einem der vorhergehenden Ansprüche,
**dadurch gekennzeichnet,**
**dass** dieses eine Schichtstruktur und eine Trägerfolie (61) aufweist.

13. OPV-Element (20) nach einem der vorhergehenden Ansprüche,
**dadurch gekennzeichnet,**
**dass** es zur Ausbildung eines OPV-Panels (10) neben einem oder mehreren weiteren OPV-Elementen (20) angeordnet ist, wobei die OPV-Elemente (20) bezüglich ihrer jeweiligen Längsrichtung (L) parallel zueinander ausgerichtet sind.

14. Verfahren zur Herstellung eines OPV-Elementes (20) nach einem der Ansprüche 1 bis 12 mit Hilfe eines Rollendruck- oder Rollenauftragungsverfahrens.

## Claims

1. Organic photovoltaic (OPV) element (20) extending in a lengthwise direction (L), with a plurality of modules (30, 32), wherein a periodic succession of a number of the modules (30, 32) defines a pattern with at least threefold rotational symmetry, and each of the modules (30, 32) comprises a number of submodules (40), which are interconnected by a number of connection electrodes (43), **characterized in that** the plurality of modules (30, 32) each have a number of serially connected cells (50), and **in that** each of the submodules (40) is trapezoidal comprising in each case two first base sides (41) and comprises a number of cells (50).

2. OPV element (20) according to Claim 1,
**characterized in that**
each of the modules (30, 32) is polygonal.

3. OPV element (20) according to one of the preceding claims,
**characterized in that**
each of the modules (30, 32) is triangular.

4. OPV element (20) according to Claim 3,
**characterized in that**
the periodicity of the pattern is defined by a rhombus (R) formed by two modules (30, 32) with a common triangle side (S) and the rhombus (R) has mirror symmetry along the triangle side (S) in regard to the cells (50).

5. OPV element (20) according to one of the preceding claims,
**characterized in that**
each cell (50) is trapezoidal and has two second base sides (53), each being parallel to the first base sides (41) of the submodule (40) comprising the respective cell (50).

6. OPV element (20) according to one of the preceding claims,
**characterized in that**
each of the cells (50) defines in each case a surface (51) and the surfaces (51) of different cells (50) differ by less than 10%.

7. OPV element (20) according to one of the preceding claims,
**characterized in that**
each cell (50) has a cell height (52) and the cell heights (52) differ by less than 100%, preferably less than 30%.

8. OPV element (20) according to one of the preceding claims,
**characterized in that**
it is formed as an endless web extending in the lengthwise direction (L) with a number of contact bars (22) extending in the lengthwise direction (L).

9. OPV element (20) according to Claim 8,
**characterized in that**
each module (30) has a minus pole (42a) and a plus pole (42b) and the contact bars (22) in each case electrically connect either a number of minus poles (42a) or a number of plus poles (42b).

10. OPV element (20) according to one of the preceding claims,
**characterized in that**
all modules (30, 32) are connected in parallel.

11. OPV element (20) according to one of the preceding claims,
**characterized in that**
all cells (50) of a module (30, 32) are connected in series.

12. OPV element (20) according to one of the preceding claims,
**characterized in that**
it has a layered structure and a substrate film (61).

13. OPV element (20) according to one of the preceding claims,
**characterized in that**
in order to form an OPV panel (10) it is arranged alongside one or more additional OPV elements (20), the OPV elements (20) being oriented in parallel with each other in regard to their respective lengthwise direction (L).

14. Method for the production of an OPV element (20) according to one of Claims 1 to 12 by means of a roller pressing or roller application process.

## Revendications

1. Élément photovoltaïque organique (OPV) (20) qui s'étend dans une direction longitudinale (L), avec une pluralité de modules (30, 32), dans lequel une suite périodique d'un nombre des modules (30, 32) définit un motif avec une symétrie de rotation au moins ternaire, et chacun des modules (30, 32) comprend un nombre de sous-modules (40) qui sont connectés via un nombre d'électrodes de connexion (43),
**caractérisé en ce que** la pluralité des modules (30, 32) présentent respectivement un nombre de cellules (50) connectées en série, et que
chacun des sous-modules (40) est réalisé en forme de trapèze avec respectivement deux premiers côtés de base (41) et comprend un nombre de cellules (50).

2. Élément OPV (20) selon la revendication 1,
**caractérisé en ce que** chacun des modules (30, 32) est en forme de polygone.

3. Élément OPV (20) selon l'une des revendications précédentes,
**caractérisé en ce que** chacun des modules (30, 32) est en forme de triangle.

4. Élément OPV (20) selon la revendication 3,
**caractérisé en ce que** la périodicité du motif est définie par un losange (R) défini par deux modules (30, 32) avec un côté de triangle (S) commun et que le losange (R) est à symétrie spéculaire par rapport aux cellules (50) le long du côté de triangle (S).

5. Élément OPV (20) selon l'une des revendications précédentes,
**caractérisé en ce que** chaque cellule (50) est en forme de trapèze et présente deux deuxièmes côtés de base (53) qui sont respectivement parallèles aux premiers côtés de base (41) du sous-module (40) comprenant la cellule (50) respective.

6. Élément OPV (20) selon l'une des revendications précédentes,
**caractérisé en ce que** chacune des cellules (50) définit respectivement une surface (51) et que les surfaces (51) de cellules différentes (50) diffèrent de moins de 10 %.

7. Élément OPV (20) selon l'une des revendications précédentes,
**caractérisé en ce que** chaque cellule (50) présente une hauteur de cellule (52) et que les hauteurs de cellule (52) diffèrent de moins de 100 %, de préférence de moins de 30 %.

8. Élément OPV (20) selon l'une des revendications précédentes,
**caractérisé en ce qu'**il est réalisé en tant que bande continue s'étendant dans la direction longitudinale (L) avec un nombre de rails de contact (22) s'étendant dans la direction longitudinale (L).

9. Élément OPV (20) selon la revendication 8,
**caractérisé en ce que** chaque module (30) présente un pôle négatif (42a) et un pôle positif (42b) et que les rails de contact (22) raccordent électriquement respectivement soit un nombre de pôles négatifs (42a), soit un nombre de pôles positifs (42b).

10. Élément OPV (20) selon l'une des revendications précédentes,
**caractérisé en ce que** tous les modules (30, 32) sont connectés en parallèle.

11. Élément OPV (20) selon l'une des revendications précédentes,
**caractérisé en ce que** toutes les cellules (50) d'un module (30, 32) sont connectées en série.

12. Élément OPV (20) selon l'une des revendications précédentes,
**caractérisé en ce que** celui-ci présente une structure en couches et une feuille de support (61).

13. Élément OPV (20) selon l'une des revendications précédentes,
**caractérisé en ce que**, pour la formation d'un panneau OPV (10), il est disposé à côté d'un ou de plusieurs autres éléments OPV (20), dans lequel les éléments OPV (20) sont, concernant leur direction longitudinale (L) respective, orientés parallèlement entre eux.

14. Procédé pour la fabrication d'un élément OPV (20) selon l'une des revendications 1 à 12 à l'aide du procédé d'impression sur rotative ou d'application sur rotative.
